(19) Europäisches Patentamt
European Patent Office
Office européen des brevets

(11) Veröffentlichungsnummer: **0 155 542**
A2

## (12) EUROPÄISCHE PATENTANMELDUNG

(21) Anmeldenummer: 85102018.0

(22) Anmeldetag: 23.02.85

(51) Int. Cl.⁴: **H 05 K 7/10**

(30) Priorität: 23.03.84 CH 1485/84

(43) Veröffentlichungstag der Anmeldung:
25.09.85 Patentblatt 85/39

(84) Benannte Vertragsstaaten:
CH DE FR GB IT LI SE

(71) Anmelder: ELESTA AG ELEKTRONIK

CH-7310 Bad Ragaz(CH)

(72) Erfinder: Wullschleger, Rolf
Bahnhofstrasse 107
CH-7023 Haldenstein(CH)

(74) Vertreter: Riederer, Conrad A., Dr.
Bahnhofstrasse 10
CH-7310 Bad Ragaz(CH)

(54) Fassung, insbesondere für Relais.

(57) Die Fassung (10), die sich insbesondere für Relais zum Schalten von hohen Strömen eignet, weist zum Einstecken in eine gedruckte Schaltung aus dem Gehäuse (11) ragende Anschlussstifte (19) auf. Alle Anschlusstücke (21), welche der Kontaktierung der Kontaktstifte eines Relais oder dergl. dienen, sind gleich ausgebildet. Die Anschlussstücke (21), welche die z.B. über die Relaiskontakte fliessenden hohen Ströme leiten müssen, sind direkt mit den Anschlussklemmen (29) in Verbindung, so dass diese Ströme nicht über die Leiterbahnen der gedruckten Schaltung geführt werden müssen. Trotzdem weisen aber auch diese Anschlusstücke (21) einen Kontaktstift (19) auf, so dass die Möglichkeit eines Anschlusses zu einer Anzeigevorrichtung oder anderen Vorrichtungen, z.B. über die Leiterbahnen der gedruckten Schaltung, besteht. Die Fassung (10) hat eine längliche Form und die Anschlusselemente (33) der Anschlussklemmen (29) sind an einer Schmalseite angeordnet, so dass mehrere Fassungen (10) auf der gedruckten Schaltung aneinandergereiht werden können.

EP 0 155 542 A2

Fig. 1

Fig. 8

Fig. 9

0155542

## Fassung, insbesondere für Relais

Die Erfindung betrifft eine Fassung zur Verwendung auf gedruckten Schaltungen, insbesondere für Relais zum Schalten von hohen Strömen, mit einem Gehäuse aus Kunststoff, das Einstecköffnungen für Kontaktstifte eines Relais oder anderen Vorrichtungen aufweist, wobei in den Einstecköffnungen Anschlusskontaktstücke gelagert sind, von denen mindestens ein Teil mit Anschlussklemmen in Verbindung stehen.

Es sind seit längerer Zeit Relaisfassungen bekannt, die Schraubklemmen sowohl für die Spulenanschlüsse als auch für die Relaiskontakte aufweisen. Des weiteren gibt es Relaisfassungen, die mit Anschlussstiften in gedruckte Schaltungen eingelötet werden können. Hier können Probleme entstehen, wenn die Relaiskontakte relativ hohe Ströme schalten müssen, welche über Leiterbahnen der gedruckten Schaltung geführt werden. Diese Leiterbahnen sind in der Regel nur für relativ geringe Ströme bemessen. Es sind aber auch schon Relaisfassungen bekannt geworden, bei denen die Spulenanschlüsse über in die gedruckte Schaltung einlötbare Anschlussstifte erfolgen, währenddem für die Relaiskontakte Schraub- oder andere Klemmen vorgesehen sind, die sich für relativ hohe Ströme eignen. Wenn aber die Relaisfassung nur mit zwei Anschlussstiften auf der gedruckten Schaltung befestigt wird, ist die Gefahr gross, dass sie beim Auswechseln eines Relais aus der Schaltung herausgerissen wird. Deswegen ist auch schon eine Relaisfassung geschaffen worden, welche ausser den Kontaktanschlüssen noch blinde Anschlussstifte aufweist, die lediglich den Zweck haben, die Befestigung der Relaisfassung auf der gedruckten Schaltung zu verbessern. Diese Relaisfassung hat jedoch u.a. den Nachteil, dass sie relativ viele verschiedene Teile erfordert und dass wegen fehlender Anschlüsse für die gedruckte Schaltung keine Anzeigemittel, z.B. Glimmlämpchen, auf der gedruckten Schaltung vorgesehen werden können, welche den Schaltzustand des Schaltkreises anzeigen, in welchem sich die Relaiskontakte befinden.

Es ist Aufgabe der vorliegenden Erfindung, mindestens einen Teil der Nachteile der vorbekannten Fassungen zu vermeiden.

Zu diesem Zwecke ist bei einer Fassung der eingangs erwähnten Art vorgesehen, dass alle Anschlusskontaktstücke gleich ausgebildet sind und einen aus dem Gehäuse ragenden Anschlussstift aufweisen. Durch die gleiche Ausbildung der Anschlusskontaktstücke wird eine Verbilligung der Fassung und eine Vereinfachung der Montage erreicht. Da die Fassung nicht nur zwei aus dem Gehäuse ragende Kontaktstifte aufweist, sondern mindestens deren vier, wird beim Einlöten in die gedruckte Schaltung eine stabile Verankerung erreicht. Die Vorteile einer direkten Verbindung von den Schraubklemmen zu den Anschlusskontaktstücken bleiben erhalten, aber zudem bringen die auf der gedruckten Schaltung zusätzlich vorhandenen Anschlussstifte die Möglichkeit, z.B. einen Anschluss zu einer Anzeigevorrichtung, z.B. einer Glimmlampe, vorzunehmen.

Eine vorteilhafte Ausgestaltung der Fassung sieht vor, dass die Anschlusskontaktstücke in parallelen Reihen angeordnet sind und dass in jeder Reihe sich ein Anschlusskontaktstück findet, das mit der Anschlussklemme verbunden ist. Dies ergibt eine besonders einfache Konstruktion.

Die Anschlusskontaktstücke sind zweckmässigerweise einstückig aus Blech gefertigt. Dabei kann das jeweilige Anschlusskontaktstück mindestens zwei einander gegenüberliegende federnde Kontaktzungen aufweisen, die durch einen Steg miteinander verbunden sind. Dies ermöglicht eine billige Herstellung der Anschlusskontaktstücke. Zweckmässigerweise besitzt das Anschlusskontaktstück einen etwa in entgegengesetzter Richtung zu den Kontaktzungen verlaufenden Fortsatz, welcher den aus dem Gehäuse ragenden Anschlusstift bildet. Dieser Anschlussstift dient dann als Verankerung in der gedruckten Schaltung, auch wenn er für einen Teil der Anschlussstücke auch nicht unbedingt notwendig wäre, weil diese mit einer Anschlussklemme verbunden sind. Eine besonders zweckmässige Ausführungsform sieht vor, dass das jeweilige Kontaktstück einen etwa rechtwinklig zu den Kontaktzungen abgewinkelten Fortsatz aufweist. Bei einem Teil der Anschlusstücke kann der abgewinkelte Fortsatz mit einer Anschlussklemme verbunden sein. Bei einem anderen Teil der Anschlussstücke kann der abgewinkelte Fortsatz der Verankerung im Gehäuse dienen. Der abgewinkelte Fortsatz weist daher zweckmässigerweise eine Oeffnung auf, welche der Befestigung an der Anschlussklemme oder der Verankerung im Gehäuse dient.

Vorteilhaft sind alle Anschlussklemmen gleich ausgebildet, wobei aber bei der einen Anschlussklemme das Anschlusstück an einer ersten Nietstelle und bei einer anderen Anschlussklemme an einer zweiten Nietstelle befestigt ist. Durch die gleiche Ausbildung der Anschlussklemmen wird die Zahl der benötigten Teile auf ein Minimum reduziert.

Das Gehäuse kann verschiedene, voneinander durch Zwischenwände getrennte Aussparungen zur Aufnahme der Anschlusskontaktstücke und der Anschlussklemmen aufweisen, wobei das Niveau der Aussparungen, welche ein mit einer Anschlussklemme verbundenes Anschlusskontaktstück enthalten, tiefer liegt als das Niveau der Aussparungen, die nur ein Anschlusskontaktstück enthalten. Dies hat den Vorteil, dass die Kontaktfedernenden alle in der gleichen Ebene liegen, also alle Anschlusskontaktstücke die Kontaktstifte des Relais beim Einschieben desselben gleichzeitig erfassen.

Von besonderer Bedeutung ist, dass das Gehäuse länglich ist und die Anschlussklemmen an einer Schmalseite des Gehäuses angeordnet sind. Dies ermöglicht es nämlich, verschiedene Fassungen angrenzend aneinander auf der gedruckten Schaltung anzuordnen.

Zweckmässigerweise besteht das Gehäuse aus Unterteil und Oberteil, wobei zwischen den Aussparungen des Unterteils und des Oberteils überlappende Zwischenwände angeordnet sind. Dadurch werden lange Kriechstromwege zwischen den Anschlussklemmen erzielt, wobei aber das Gehäuse dennoch mit einfachen Werkzeugen ohne seitliche Auszüge hergestellt werden kann.

Ausführungsbeispiele der Erfindung werden nun unter Bezugnahme auf die Zeichnung beschrieben. Es zeigt:

Fig. 1 eine Fassung mit vier Einstecköffnungen für die Kontaktstifte eines Relais oder einer anderen Vorrichtung,

0155542

Fig. 2       eine Ansicht des Oberteils von unten
             gesehen,

Fig. 3       einen Längsschnitt durch das Oberteil,
             entlang der Linie III-III von Fig. 2,

Fig. 4       einen der Figur 2 entsprechenden Schnitt
             durch das Unterteil, entlang der Linie
             IV-IV in Fig. 5,

Fig. 5       eine Draufsicht auf das Unterteil,

Fig. 6       eine perspektivische Darstellung einer
             Anschlussklemme vor deren Verbindung mit
             einem Anschlusskontaktstück,

Fig. 7       eine Schraube mit Drahtschutzteil für die
             Klemme von Figur 6,

Fig. 8       ein Anschlusskontaktstück,

Fig. 9       eine Anschlussklemme gemäss Figur 6, verbunden mit einem Anschlusskontaktstück gemäss
             Figur 8,

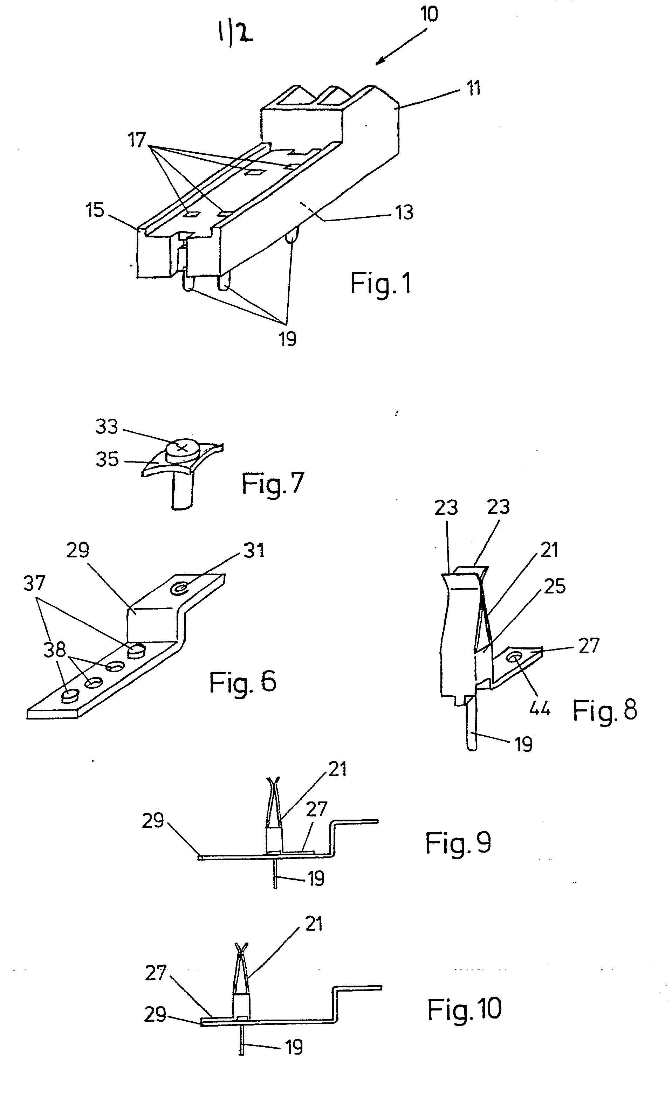

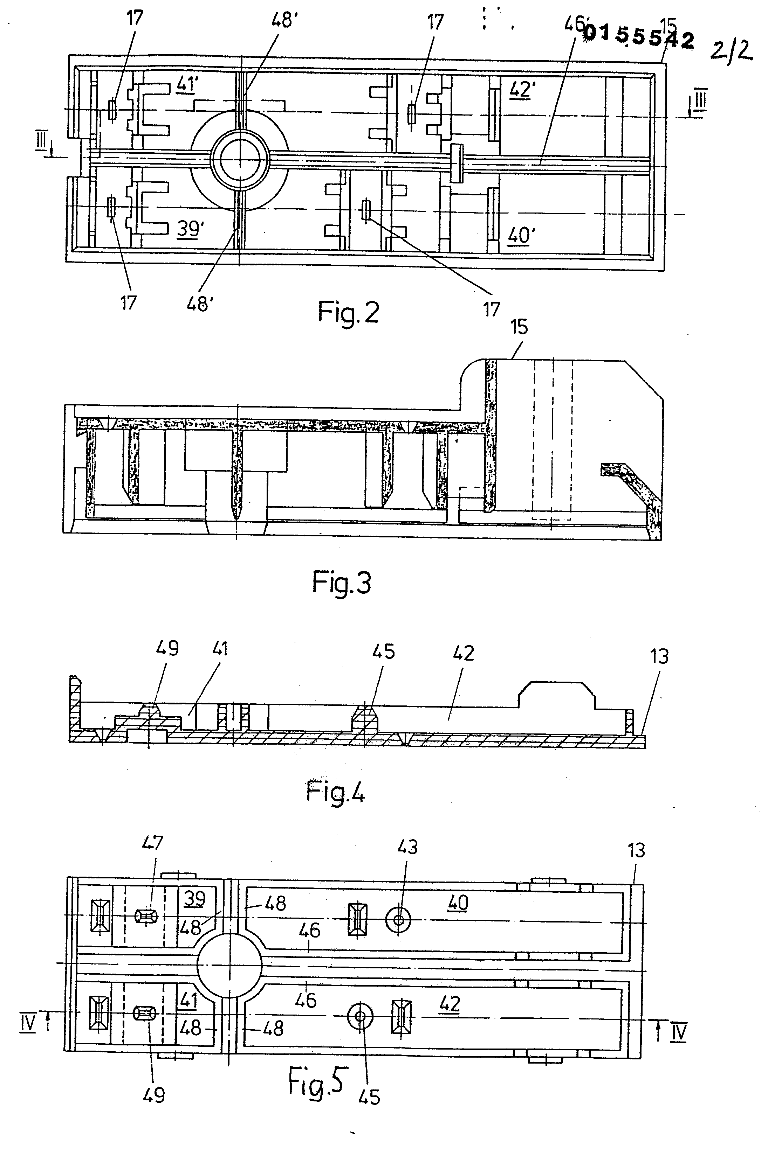

Fig. 10      eine Klemme wie in Figur 9, wobei jedoch das
             Anschlusskontaktstück um 180$^\circ$ verdreht an
             einer anderen Stelle befestigt ist.

Die Fassung 10 gemäss Figur 1 besitzt ein Gehäuse 11 aus Kunststoff mit einem Unterteil 13 und einem Oberteil 15. Im Oberteil 15 sind vier Einstecköffnungen 17 für die Kontaktstifte des einzusetzenden Relais oder einer anderen Vorrichtung sichtbar. Aus dem Unterteil 13 ragen vier Anschlussstifte 19 zum Einlöten in eine gedruckte Schaltung.

Bevor nun weitere Einzelheiten des Gehäuses 11 beschrieben werden, ist es zweckmässig, die im Gehäuse verwendeten Anschlusskontaktstücke zu betrachten. Diese sind alle gleich ausgebildet. Figur 8 zeigt eine mögliche Ausführungsform eines Anschlusskontaktstücks 21. Dieses Anschlusskontaktstück 21 ist einstückig aus Blech gefertigt. Es weist mindestens zwei einander gegenüberliegende federnde Kontaktzungen 23 auf, die durch einen oder mehrere Stege 25 miteinander verbunden sind. Ein etwa in entgegengesetzter Richtung zu den Kontaktzungen verlaufender Fortsatz bildet den Anschlussstift 19, der nach dem Einlegen der Anschlusskontaktstücke 21 aus dem Gehäuse 11 (Fig. 1) ragt. Das Anschlusskontaktstück 21 weist ferner einen etwa rechtwinklig zu den Kontaktzungen 23 abgewinkelten Fortsatz 27 auf.

Die Anschlusskontaktstücke 21 sind im Gehäuse 11 in parallelen Reihen angeordnet, wobei sich in jeder Reihe ein Anschlusskontaktstück 21 findet, das mit einer Anschlussklemme verbunden ist. Eine solche Anschlussklemme 29, vor ihrer Befestigung mit einem Anschlusskontaktstück 21, ist in Figur 6 dargestellt. Sie besteht aus einem doppelt abgewinkelten Blechstück, welches an einem Ende eine Gewindebohrung 31 zur Aufnahme einer Schraube 33 mit einem Drahtschutzstück 35 aufweist. Des weiteren sind an der Anschlussklemme 29 zwei Butzen 37 vorgesehen, welche in die Oeffnung 44 des Anschlusskontaktstücks 21 passen. Die beiden Teile 21 und 29 können

0155542

daher mit einem Butzen 37 in zwei verschiedenen Stellungen miteinenader vernietet werden, wie dies in den Figuren 9 und 10 dargestellt ist. Dabei ragt der Anschlussstift 19 durch eine Oeffnung 38 (Fig. 6) der Anschlussklemme 29.

Einzelheiten der Gehäusekonstruktion sind aus den Figuren 2 bis 5 ersichtlich. Vier Aussparungen 39 bis 42 im Unterteil 13 dienen der Aufnahme der Anschlusskontaktstücke 21 und der Anschlussklemmen 29. Die Aussparungen 39 bis 42 sind durch Zwischenwände 46, 48 voneinander getrennt. Das Niveau der Aussparungen 40 und 42, welche ein mit einer Anschlussklemme 29 verbundenes Anschlusskontaktstück 21 aufnehmen, liegt etwas tiefer als das Niveau der Aussparungen 39 und 41, die lediglich ein Anschlusskontaktstück 21 aufnehmen. In die Aussparung 40 passt die Einheit gemäss Figur 10, währenddem in die Aussparung 42 die Einheit gemäss Figur 9 passt. Die Stifte 43 bzw. 45 ragen durch ein Loch 38 der Klemme 29 und sorgen damit für eine genaue Positionierung des Anschlusstücks 21. In gleicher Weise sorgen Stifte 47 und 49, welche durch die Oeffnung 44 der Anschlusskontaktstücke 21 ragen, für die genaue Positionierung dieser Anschlusskontaktstücke 21.

Den Aussparungen 39 bis 42 im Unterteil 13 (Fig. 5) entsprechen Aussparungen 39' bis 42' im Oberteil (Fig. 2). Die Aussparungen 39' bis 42' sind durch Zwischenwände 46', 48' voneinander getrennt. Beim Zusammensetzen des Gehäuses 11 überlappen die Zwischenwände 46, 46' und 48, 48'. Diese Ausgestaltung des Gehäuses 11 aus zwei Teilen 13, 15 ermöglicht dessen Herstellung mit einfachen Werkzeugen.

Es sind verschiedene Aenderungen der Fassung 10 möglich, ohne von der Erfindungsidee abzuweichen. So können beispielsweise bei entsprechend vergrössertem Gehäuse 11 statt zwei parallele Reihen von Einstecköffnungen 17 mit Anschlusskontaktstücken 21 auch drei oder mehr Reihen vorgesehen sein. Wenn das Anschlusstück 21 durch die Anschlussklemme 29 hindurchragt, also mit dem Fortsatz 27 unten an der Anschlussklemme 29 befestigt ist, können die Aussparungen 39 und 41 das gleiche Niveau aufweisen. Ferner ist eine andere Anordnung der Einstecköffnungen 17 möglich, wobei auch noch andere als die in den Figuren 8 und 9 gezeigten Anordnungen der Anschlusstücke 21 auf den Anschlussklemmen 29 möglich sind, indem z.B. noch weitere Butzen 37 und Oeffnungen 38 vorgesehen sind.

Patentansprüche

1. Fassung zur Verwendung auf gedruckten Schaltungen, insbesondere für Relais zum Schalten von hohen Strömen, mit einem Gehäuse (11) aus Kunststoff, das Einstecköffnungen (17) für Kontaktstifte eines Relais aufweist, wobei in den Einstecköffnungen (17) Anschlusstücke (21) gelagert sind, von denen mindestens ein Teil mit Anschlussklemmen (29) in Verbindung stehen, dadurch gekennzeichnet, dass alle Anschlusskontaktstücke (21) gleich ausgebildet sind und einen aus dem Gehäuse (11) ragenden Anschlussstift (19) aufweisen.

2. Fassung nach Anspruch 1, dadurch gekennzeichnet, dass die Anschlusskontaktstücke (21) in parallelen Reihen angeordnet sind und dass in jeder Reihe sich ein Anschlusskontaktstück (21) findet, das mit einer Anschlussklemme (29) verbunden ist.

3. Fassung nach Anspruch 1 oder 2, dadurch gekennzeichnet, dass die Anschlusskontaktstücke (21) aus Blech gefertigt sind.

4. Fassung nach einem der Ansprüche 1 bis 3, dadurch gekennzeichnet, dass das jeweilige Anschlusskontaktstück (21) mindestens zwei einander gegenüberliegende federnde Kontaktzungen (23) aufweist, die durch einen Steg (25) miteinander verbunden sind.

5. Fassung nach Anspruch 4, dadurch gekennzeichnet, dass das Anschlusskontaktstück (21) einen etwa in entgegengesetzter Richtung zu den Kontaktzungen (23) verlaufenden Fortsatz besitzt, welcher den aus dem Gehäuse (11) ragenden Anschlussstift (19) bildet.

6. Fassung nach Anspruch 4 oder 5, dadurch gekennzeichnet, dass das Anschlusskontaktstück (21) einen etwa rechtwinklig zu den Kontaktzungen (23) abgewinkelten Fortsatz (27) aufweist.

7. Fassung nach Anspruch 6, dadurch gekennzeichnet, dass bei einem Teil der Anschlusstücke (21) der abgewinkelte Fortsatz mit einer Anschlussklemme (29) verbunden ist.

8. Fassung nach Anspruch 6 oder 7, dadurch gekennzeichnet, dass der abgewinkelte Fortsatz (27) eine Oeffnung (44) aufweist.

9. Fassung nach einem der Ansprüche 6 bis 8, dadurch gekennzeichnet, dass alle Anschlussklemmen (29) gleich ausgebildet sind, dass aber bei der einen Anschlussklemme (29) das Anschlusskontaktstück an einer ersten Nietstelle (37) und bei der anderen Klemme an einer anderen Nietstelle (37) befestigt ist.

10. Fassung nach einem der Ansprüche 1 bis 9, dadurch gekennzeichnet, dass das Gehäuse (11) verschiedene, voneinander durch Zwischenwände getrennte Aussparungen (39 bis 42) zur Aufnahme der Anschlusskontaktstücke (21) und Anschlussklemmen (29) aufweist, wobei das Niveau der Aussparungen (40, 42), welche ein mit einer Anschlussklemme (29) verbundenes Anschlusskontaktstück (21) enthalten, tiefer liegt, als das Niveau der Aussparungen (39, 41), die nur ein
Anschlusskontaktstück (21) enthalten.

11. Fassung nach einem der Ansprüche 1 bis 10, dadurch gekennzeichnet, dass das Gehäuse (11) länglich ist und die Anschlusselemente (33) der Anschlussklemmen (29) an einer Schmalseite des Gehäuses (11) angeordnet sind.

12. Fassung nach einem der Ansprüche 1 bis 11, dadurch gekennzeichnet, dass das Gehäuse aus Unterteil (13) und Oberteil (15) besteht, und dass zwischen den Aussparungen (39, 40, 41, 42; 39', 40', 41', 42') des Unterteils (13) und des Oberteils (15) überlappende Zwischenwände (46, 48; 46', 48') angeordnet sind.

0155542

1/2

Fig.1

Fig.7

Fig.6

Fig.8

Fig.9

Fig.10

**Fig. 2**

**Fig.3**

**Fig.4**

**Fig.5**

0155542  2/2